# EUROPEAN PATENT APPLICATION

(11) **EP 2 317 548 A1**
(43) Date of publication of application: **04.05.2011**
(21) Application number: 09794440.9
(22) Date of filing: 07.07.2009
(51) Int. Cl.: H01L 23/36, H05K 7/20, H05K 9/00

(54) **HEAT-CONDUCTIVE NOISE SUPPRESSION SHEET**

(30) Priority: 10.07.2008 JP 2008179664
(71) Applicant: Alps Electric Co., Ltd., Tokyo 145-8501 (JP)
(72) Inventor: TAKAHASHI, Toshio, Tokyo 145-8501 (JP); MATSUI, Masao, Tokyo 145-8501 (JP); MARUYAMA, Satoshi, Tokyo 145-8501 (JP); ARAKI, Keiichi, Tokyo 145-8501 (JP)
(74) Representative: Klunker . Schmitt-Nilson . Hirsch
(86) International application number: PCT/JP2009/062377
(87) International publication number: WO 2010/004996

(57) **Abstract**

[Object] To provide a heat-conductive noise suppression sheet having a high noise suppression effect over a wide frequency range, in particular, from several hundred megahertz to several gigahertz, and high thermal conductivity.

[Solution] A heat-conductive noise suppression sheet according to an embodiment includes at least first ferrite particles 4, second ferrite particles 5, and a matrix material 7. The first ferrite particles 4 are spherical particles having an average particle diameter in the range of 50 µm to 150 µm, the content of the first ferrite particles 4 with respect to the total amount of solid components being in the range of 5 vol% to 25 vol%. The second ferrite particles 5 are irregularly shaped particles having an average particle diameter in the range of 50 µm or less, the content of the second ferrite particles 5 with respect the total amount of solid components being in the range of 5 vol% to 45 vol%.

## Description

### Technical Field

The present invention relates to a heat-conductive noise suppression sheet having a high noise suppression effect over a wide frequency range from the hundred megahertz range to the gigahertz range and high thermal conductivity.

### Background Art

As described in Patent Literatures listed below, structures in which a heat-conductive noise suppression sheet is interposed between a semiconductor component, such as an IC, and a heat sink are known.

A heat-conductive noise suppression sheet for the above-described use converts electromagnetic energy emitted from the semiconductor component into thermal energy, and conducts the thermal energy through the sheet so as to radiate heat to the heat sink.

PTL 1 discloses a technique of increasing the noise suppression effect by increasing the imaginary part µ" of the complex relative permeability.

However, it has been found that it is difficult to effectively increase the noise suppression effect in both the hundred megahertz range and the gigahertz range simply by adjusting the imaginary part µ" of the complex relative permeability.

In addition, it is necessary not only to increase the noise suppression effect, but also to effectively increase the thermal conductivity.

However, it has been found that even when the coefficient of thermal conductivity is increased by increasing the content of filler, the thermal conductivity cannot be effectively increased, owing to a reduction in compressibility. The heat-conductive noise suppression sheet is disposed between the semiconductor component, such as an IC, and the heat sink in such a manner that the heat-conductive noise suppression sheet is compressed. If the compressibility of the sheet is low, the adhesion between the sheet and the heat sink and the adhesion between the sheet and the substrate decrease, which causes a reduction in thermal conductivity.

### Citation List

### Patent Literature

PTL 1: Japanese Unexamined Patent Application Publication No. 2001-68312.
PTL 2: Japanese Unexamined Patent Application Publication (Translation of PCT Application) No. 2006-504272.

### Summary of Invention

### Technical Problem

The present invention has been made to solve the above-described problem of the related art, and an object of the present invention is to provide a heat-conductive noise suppression sheet having a high noise suppression effect over a wide frequency range from the hundred megahertz range to the gigahertz range and high thermal conductivity.

### Solution to Problem

A heat-conductive noise suppression sheet according to the present invention includes first ferrite particles, second ferrite particles, a heat-conducting material, and a matrix material.

The first ferrite particles are spherical particles having an average particle diameter in the range of 50 µm to 150 µm, the content of the first ferrite particles with respect to the total amount of solid components being in the range of 5 vol% to 25 vol%.

The second ferrite particles are irregularly shaped particles having an average particle diameter in the range of 50 µm or less, the content of the second ferrite particles with respect the total amount of solid components being in the range of 5 vol% to 45 vol%.

According to the present invention, attention is focused not only on the imaginary part µ" of the complex relative permeability but also on the imaginary part ε" of the complex relative permittivity to obtain a high noise suppression effect over a wide frequency range from the hundred megahertz range to the gigahertz range. More specifically, according to the present invention, the imaginary part µ" of the complex relative permeability can be increased in the hundred megahertz range. Even though the imaginary part µ" of the complex relative permeability is reduced in the gigahertz range, according to the present invention, the imaginary part ε" of the complex relative permittivity can be reduced in the gigahertz range. Therefore, a high noise suppression effect can be obtained over a wide frequency range from the hundred megahertz range to the gigahertz range.

According to the present invention, the first ferrite particles, which are spherical particles having a larger average particle diameter than that of the second ferrite particles, are contained and the content of the first ferrite particles is appropriately regulated. Therefore, the compressibility can be increased while maintaining a high coefficient of thermal conductivity. As a result, the thermal conductivity can be effectively increased.

In the present invention, the content of the first ferrite is preferably 10 vol% or more, and more preferably, 20 vol% or more.

In addition, in the present invention, the content of the second ferrite is preferably 30 vol% or more.

In addition, in the present invention, the content of the first ferrite particles may be in the range of 20 vol% to 25 vol%, and the content of the second ferrite particles may be in the range of 10 vol% to 20 vol%. According to the present invention, the content of the second ferrite particles may be set to a relatively small value by setting the content of the first ferrite particles to a relatively large value. In such a case, even when the total filler content is not very large, a high noise suppression effect can be obtained. In addition, a high coefficient of thermal conductivity and high compressibility can be obtained, so that high thermal conductivity can be obtained.

In the present invention, the irregularly shaped particles are preferably formed by crushing the spherical particles.

In the present invention, a heat-conducting material may be additionally contained. More specifically, preferably, the heat-conducting material is aluminum oxide having an average particle diameter in the range of 5 µm to 25 µm, and the content of the heat-conducting material with respect to the total amount of solid components is in the range of 2.5 vol% to 10 vol%.

In the present invention, preferably, the matrix material is silicone gel, and the content of the matrix material with respect to the total amount of solid components is in the range of 30 vol% to 57.5 vol%.

### Advantageous Effects of Invention

According to the heat-conductive noise suppression sheet of the present invention, a high noise suppression effect can be obtained over a wide frequency range from the hundred megahertz range to the gigahertz range. In addition, high thermal conductivity can be obtained.

### Brief Description of Drawings

[Fig. 1] Fig. 1 is a sectional view illustrating the manner in which a heat-conductive noise suppression sheet according to the present embodiment is used.
[Fig. 2] Fig. 2 is a schematic diagram illustrating the inner structure of the sheet according to the present embodiment.
[Fig. 3] Fig. 3 is a graph showing the frequency characteristics of the imaginary part µ" of the complex relative permeability of Example, Related-Art Example 1, and Comparative Example 1.
[Fig. 4] Fig. 4 is a graph showing the frequency characteristics of the imaginary part ε" of the complex relative permittivity of Example, Related-Art Example 1, and Comparative Example 1.
[Fig. 5] Fig. 5 is a graph showing the frequency characteristics of the amount of noise reduction in Example, Related-Art Example 1, and Comparative Example 1.
[Fig. 6] Fig. 6 is a cross-sectional photograph (SEM photograph) of Example.
[Fig. 7] Fig. 7 is a cross-sectional photograph (SEM photograph) of Related-Art Example 1.
[Fig. 8] Fig. 8 shows schematic diagrams illustrating heat distribution along cross sections of analysis models containing different numbers of first ferrite particles (spherical particles).
[Fig. 9] Fig. 9 is a cross-sectional photograph (SEM photograph) of Comparative Example 8.

### Description of Embodiments

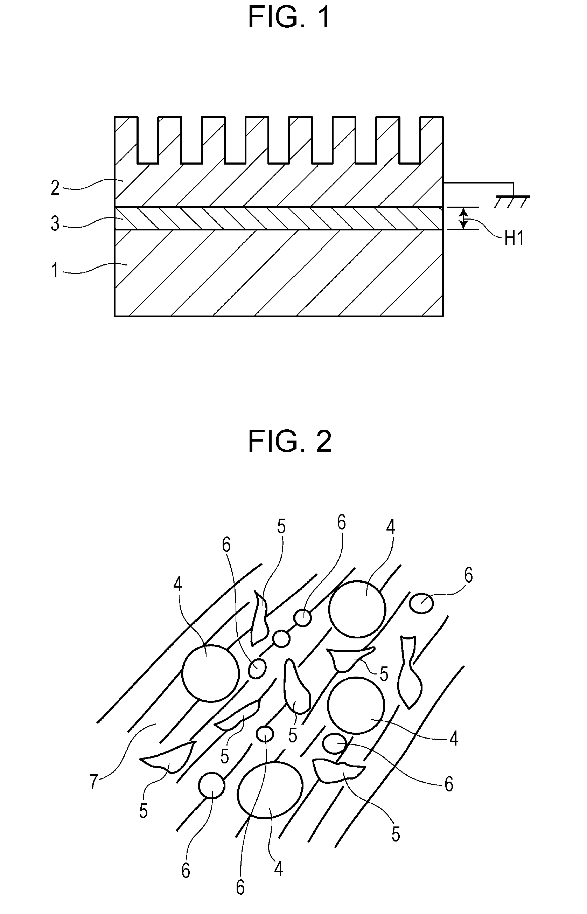

Fig. 1 is a sectional view illustrating the manner in which a heat-conductive noise suppression sheet according to the present embodiment is used. Fig. 2 is a schematic diagram illustrating the inner structure of the sheet.

Referring to Fig. 1, reference numeral 1 denotes a semiconductor component, such as an IC, and reference numeral 2 denotes a heat sink. A heat-conductive noise suppression sheet 3 according to the present embodiment is provided between the semiconductor component 1 and the heat sink 2. The heat-conductive noise suppression sheet 3 and the semiconductor component 1 are in close contact with each other, and the heat-conductive noise suppression sheet 1 and the heat sink 2 are also in close contact with each other.

The thickness H1 of the heat-conductive noise suppression sheet 3 according to the present embodiment is about 1 mm to 5 mm.

As illustrated in Fig. 2, the heat-conductive noise suppression sheet 3 contains first ferrite particles 4, second ferrite particles 5, a heat-conducting material 6, and a matrix material 7.

The first ferrite particles 4 are spherical particles having an average particle diameter in the range of 50 µm to 150 µm, and the content of the first ferrite particles 4 with respect to the total amount of solid components is in the range of 5 vol% to 25 vol%. Here, "spherical particles" are particles that have no corners on the surface and that have a degree of flatness (aspect ratio) in the range of 1 to 2. In this description, the "average particle diameter" is the particle diameter corresponding to a cumulative value of 50% (D50).

The content of the first ferrite particles 4 is preferably in the range of 10 vol% to 25 vol%, and more preferably, in the range of 20 vol% to 25 vol%.

The second ferrite particles 5 are irregularly shaped particles having an average particle diameter in the range of 50 µm or less, and the content of the second ferrite particles 5 with respect to the total amount of solid components is in the range of 5 vol% to 45 vol%. The "irregularly shaped particles" are particles other than spherical particles that have various different shapes. The average particle diameter of the second ferrite particles 5 is smaller than the average particle diameter of the first ferrite particles 4.

The content of the second ferrite particles 5 is preferably in the range of 30 vol% to 45 vol%.

The second ferrite particles 5, which are irregularly shaped particles, are preferably formed by crushing the first ferrite particles 4, which are spherical particles. Conformability to the matrix material 7 can be increased by adding the second ferrite particles 5.

Existing ferrites, such as Mn-Zn ferrite and Ni-Zn ferrite, may be used as the first ferrite particles 4 and the second ferrite particles 5.

The heat-conducting material 6 may be, for example, aluminum oxide, magnesium oxide, zinc oxide, titanium oxide, aluminum nitride, boron nitride, or silicon nitride. Preferably, the heat-conducting material 6 is aluminum oxide. The heat-conducting material 6 preferably has an average particle diameter in the range of 5 µm to 25 µm, and the content of the heat-conducting material 6 with respect to the total amount of solid components is preferably in the range of 2.5 vol% to 10 vol%, and more preferably, in the range of 5 vol% to 7 vol%.

The heat-conducting material 6 may be omitted. In such a case, the sheet includes the first ferrite particles 4, the second ferrite particles 5, and the matrix material 7.

Silicone gel is preferably used as the matrix material 7 to increase the heat resistance and tackiness (adhesion) of the sheet. The content of the matrix material 7 with respect to the total amount of solid components is preferably in the range of 30 vol% to 57.5 vol%, and more preferably, in the range of 35 vol% to 45 vol%.

According to the heat-conductive noise suppression sheet 3 of the present embodiment, the imaginary part µ" of the complex relative permeability can be increased in the hundred megahertz range. More specifically, the imaginary part µ" of the complex relative permeability can be set to 3 or more. According to the present embodiment, the imaginary part ε" of the complex relative permittivity can be reduced in the gigahertz range. More specifically, the imaginary part ε" of the complex relative permittivity can be set to 0.2 or less.

In the present embodiment, a predetermined amount of first ferrite particles 4, which are spherical particles, having a predetermined particle diameter is added. The addition of the first ferrite particles 4 is considered to contribute to the increase in the imaginary part µ" of the complex relative permeability in the hundred megahertz range. In the present embodiment, similar to the related art, the imaginary part µ" of the complex relative permeability tends to decrease in the gigahertz range. Accordingly, in the present embodiment, to increase the noise suppression effect in the gigahertz range even when the imaginary part µ" of the complex relative permeability is small, attention is focused on the imaginary part ε" of the complex relative permittivity.

In the present embodiment, as described above, the imaginary part ε" of the complex relative permittivity is reduced in the gigahertz range. The fact that the imaginary part ε" of the complex relative permittivity is small means that the insulation resistance is high.

In the present embodiment, the addition of a predetermined amount of second ferrite particles 5, which are irregularly shaped particles, having a predetermined particle diameter contributes to the reduction in the imaginary part ε" of the complex relative permittivity in the gigahertz range. The second ferrite particles 5, which are the irregularly shaped particles, added in the present embodiment suppress deposition phenomenon and the like of the first ferrite particles in the manufacturing process. Since the second ferrite particles 5, which are highly conformable to the matrix material 7, are moderately dispersed between the first ferrite particles 4, the ferrite particles do not easily come into contact with each other, so that the insulation resistance is increased. This is considered to be the reason why the imaginary part ε" of the complex relative permittivity is reduced. The addition of the heat-conducting material 6, which is added to increase the thermal conductivity, is considered to be another reason for the reduction in the imaginary part ε" of the complex relative permittivity.

As described above, in the present embodiment, the imaginary part µ" of the complex relative permeability can be increased in the hundred megahertz range. Even though the imaginary part µ" of the complex relative permeability is reduced in the gigahertz range, in the present embodiment, the imaginary part ε" of the complex relative permittivity can be reduced in the gigahertz range. Accordingly, electromagnetic energy can be appropriately converted into thermal energy in a wide frequency range from the hundred megahertz range to the gigahertz range, and the thermal energy can be appropriately radiated from the inside of the sheet to the outside, owing to the thermal conductivity. Therefore, the heat-conductive noise suppression sheet 3 according to the present embodiment provides a high noise suppression effect over a wide frequency range from the hundred megahertz range to the gigahertz range.

In addition, the heat-conductive noise suppression sheet 3 according to the present embodiment provides high thermal conductivity.

To increase the thermal conductivity, it is essential to increase the coefficient of thermal conductivity of the sheet 3 itself while increasing the compressibility thereof at the same time. More specifically, even when the coefficient of thermal conductivity is increased, the thermal conductivity is reduced if the compressibility is low.

According to the present embodiment, the first ferrite particles 4, which are spherical particles having a larger average particle diameter than that of the second ferrite particles 5, are contained. The coefficient of thermal conductivity can be increased by adding the first ferrite particles 4. However, when the content of the first ferrite particles 4 is excessively increased, the compressibility decreases. As illustrated in Fig. 1, the heat-conductive noise suppression sheet 3 is interposed between the semiconductor component 1 and the heat sink 2. The thickness of the heat-conductive noise suppression sheet 3 is reduced when the heat-conductive noise suppression sheet 3 is pressed in the thickness direction by, for example, a housing. At this time, if the compressibility of the heat-conductive noise suppression sheet 3 is high, the adhesion between the heat-conductive noise suppression sheet 3 and the semiconductor component 1 and the adhesion between the heat-conductive noise suppression sheet 3 and the heat sink 2 can be increased. As a result, the thermal conductivity can be increased.

In the present embodiment, the first ferrite particles 4, which are spherical particle size, are contained and the content thereof is in the range of 5 vol% to 25 vol%. In addition, an amount of second ferrite particles 5 that is appropriate in consideration of, for example, the noise suppression effect is also contained. Therefore, a noise suppression effect and high thermal conductivity can both be obtained.

In the present embodiment, the total content calculated by adding the contents of the first ferrite particles 4, the second ferrite particles 5, and the heat-conducting material 6 (the total content of the ferrite particles 4 and 5 when the heat-conducting material 6 is omitted) is preferably about 50 vol% to 60 vol%. In such a case, high compressibility can be obtained, and high thermal conductivity can be obtained accordingly.

If a sufficient amount, such as 20 vol% to 25 vol%, of first ferrite particles 4 is contained, even when the content of the second ferrite particles 5 or the sum of the contents of the second ferrite particles 5 and the heat-conducting material 6 is set to a small amount, such as 10 vol% to 20 vol%, a noise suppression effect and high thermal conductivity can be obtained. This embodiment is suitable for an application in which high thermal conductivity is needed even if the noise suppression effect is reduced as a result of reduction in the content of the second ferrite particles 5.

In addition to the first ferrite particles 4, the second ferrite particles 5, the heat-conducting material 6, and the matrix material 7, the heat-conductive noise suppression sheet 3 according to the present embodiment may further contain silane coupling agent, platinum catalyst, flame retarder, etc., as necessary.

In the present embodiment, the first ferrite particles 4, the second ferrite particles 5, and the heat-conducting material 6 are added to solution of the matrix material 7 and stirred so that slurry is formed. As described above, the second ferrite particles 5, which are irregularly shaped particles, are preferably formed by crushing the first ferrite particles 4, which are spherical particles. The sheet-shaped heat-conductive noise suppression sheet 3 is formed by, for example, subjecting the slurry to a coating process by a doctor blade method and a heating process. In the present embodiment, instead of using the solution, the sheet may be formed by, for example, hot-pressing a mixture of the matrix material 7, the first ferrite particles 4, the second ferrite particles 5, and the heat-conducting material 6.

### EXAMPLES

The following samples (heat-conductive noise suppression sheets) were prepared.

### (EXAMPLE 1)

(1) First Ferrite Particles (Spherical Particles): KNI-109GS (Ni-Zn ferrite) manufactured by JFE Chemical Corporation was used. The average particle diameter was 100 µm. The content with respect to the total amount of solid components was 20 vol%.
(2) Second Ferrite Particles (Irregularly shaped Particles): KNI-109GSM (Ni-Zn ferrite) manufactured by JFE Chemical Corporation was used. The average particle diameter was 40 µm. The content with respect to the total amount of solid components was 35 vol%.
(3) Heat-Conducting Material: Aluminum oxide (AS-40 manufactured by Showa Denko K.K.) having an average particle diameter of 12 µm was used. The content with respect to the total amount of solid components was 5 vol%.
(4) Matrix Material: Silicone gel (SE1896FR manufactured by Toray Dow Corning Silicone Co. Ltd.) was used. The content with respect to the total amount of solid components was 40 vol%.

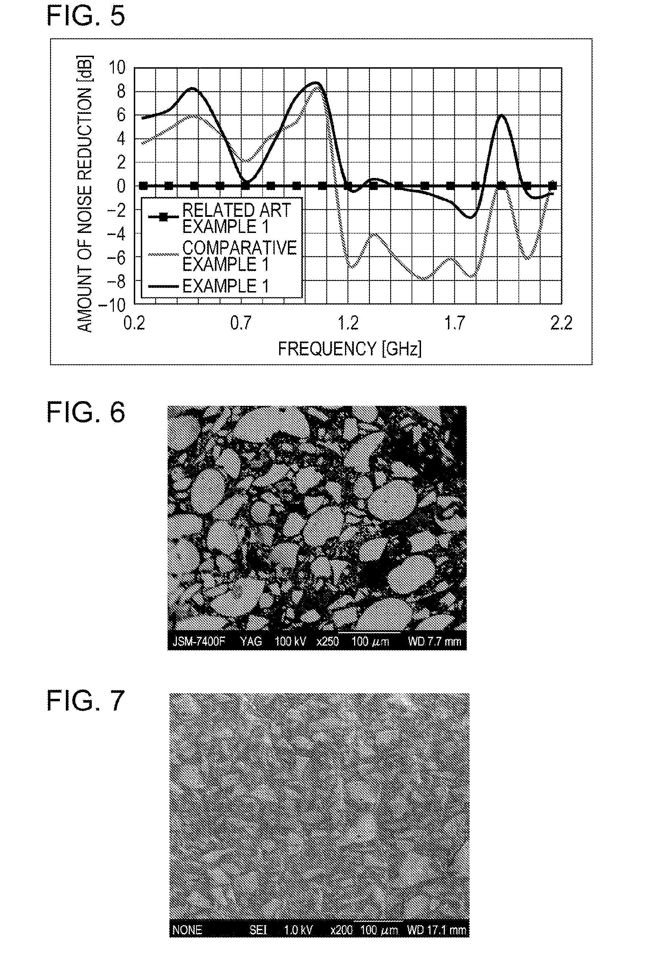

Fig. 6 is a cross-sectional photograph (SEM photograph) of the heat-conductive noise suppression sheet of Example. As is clear from Fig. 6, the first ferrite particles, which are spherical particles, are dispersed without clumping. The second ferrite particles, which are irregularly shaped particles, the heat-conducting material, and the matrix material are present between the first ferrite particles. The matrix material is present between the particles so as to fill the spaces between the particles without leaving voids.

### (RELATED-ART EXAMPLE 1)

E7000K manufactured by Sony Chemical Corporation was used. It was found by analysis that the heat-conductive noise suppression sheet of Related-Art Example 1 contained Ni-Zn ferrite particles, aluminum oxide particles, and silicone gel. Fig. 7 is a cross-sectional photograph (SEM photograph) of the heat-conductive noise suppression sheet according to Related-Art Example 1. It is clear from Fig. 7 that the Ni-Zn ferrite particles are irregularly shaped particles that correspond to the second ferrite particles according to Example.

### (COMPARATIVE EXAMPLE 1)

(1) First Ferrite Particles (Spherical Particles): KNI-109GS manufactured by JEF Chemical Corporation was used.
   The average particle diameter was 100 µm. The content with respect to the total amount of solid components was 55 vol%.
(2) Heat-Conducting Material: Aluminum oxide (AS-40 manufactured by Showa Denko K.K.) having an average particle diameter of 12 µm was used. The content with respect to the total amount of solid components was 5 vol%.
(3) Matrix Material: Silicone gel (SE1896FR manufactured by Toray Dow Corning Silicone Co. Ltd.) was used. The content with respect to the total amount of solid components was 40 vol%.

In the experiment, the frequency characteristics of the imaginary part µ" of the complex relative permeability, the frequency characteristics of the imaginary part ε" of the complex relative permittivity, and the frequency characteristics of the amount of noise reduction were measured for each sample.

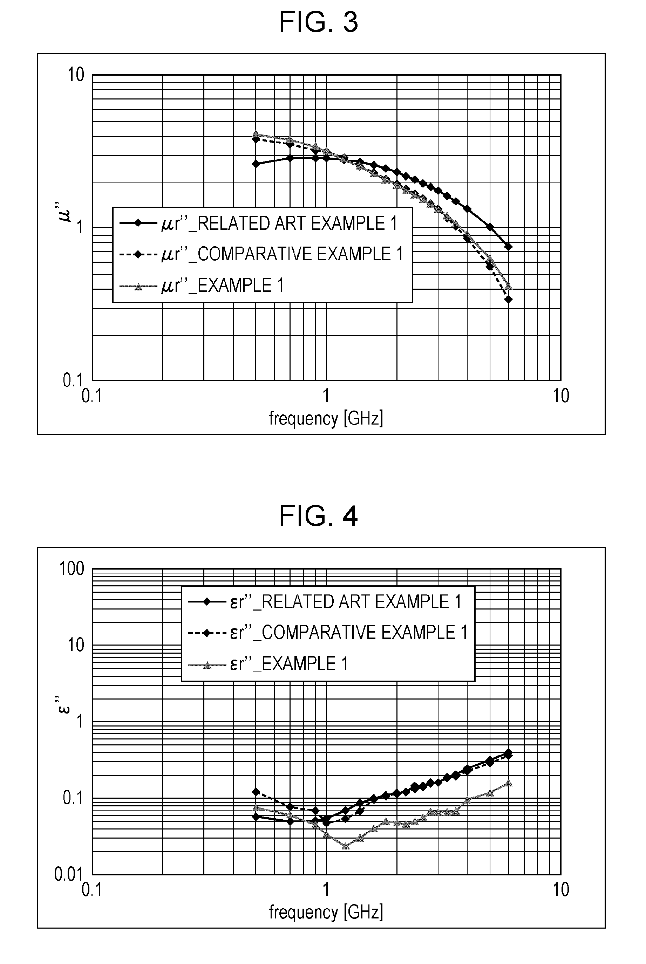

Fig. 3 is a graph showing the frequency characteristics of the imaginary part µ" of the complex relative permeability of each sample.

As is clear from Fig. 3, in the hundred megahertz frequency range, the imaginary part µ" of the complex relative permeability of Example 1 is greater than that of Related-Art Example 1, and is substantially equal to that of Comparative Example 1.

Fig. 4 is a graph showing the frequency characteristics of the imaginary part ε" of the complex relative permittivity of each sample.

As is clear from Fig. 4, in the frequency range of about 1 GHz or more, the imaginary part ε" of the complex relative permittivity of Example 1 is smaller than those of Related-Art Example 1 and Comparative Example 1.

Thus, according to Example, the imaginary part µ" of the complex relative permeability can be effectively increased in the frequency range of several hundred megahertz, and the imaginary part ε" of the complex relative permittivity can be effectively reduced in the frequency range of 1 GHz or more.

Fig. 5 is a graph showing the frequency characteristics of the amount of noise reduction in each sample. The amount of noise reduction was measured by a spectrum analyzer with a tracking generator (hereinafter referred to as TG). More specifically, a measurement system which serves as a model of a noise propagation path from the TG to the spectrum analyzer through the sample and a radiating metal component was prepared. In this measurement system, a signal intensity was measured in each of the case in which the sample was present and the case in which the sample was absent, and the noise reduction performance was determined from the difference between the measured signal intensities.

The vertical axis in Fig. 5 shows the amount of noise reduction. The amount of noise reduction of Related-Art Example 1 is defined as a reference value, and the amounts of noise reduction of Example 1 and Comparative Example 1 are expressed as the differences from the reference value. Therefore, in Fig. 5, if the amount of reduction is positive, it means that the amount of noise reduction is greater than that of Related-Art Example 1. If the amount of reduction is negative, it means that the amount of noise reduction is smaller than that of Related-Art Example 1.

As is clear from Fig. 5, the amount of noise reduction of Example in the hundred megahertz range is equivalent to that of Comparative Example 1, and is greater than that of Related-Art Example 1. In addition, the amount of noise reduction of Example in the gigahertz range is greater than that of Comparative Example 1, and is equivalent to or greater than that of Related-Art Example 1.

According to Related-Art Example 1, in which the ferrite particles are irregularly shaped particles, the noise suppression effect is relatively high in the gigahertz range, but is low in the hundred megahertz range.

According to Comparative Example 1, in which the ferrite particles are spherical particles, the noise suppression effect is high in the hundred megahertz range, but is low in the gigahertz range.

In contrast, according to Example 1, in which both the first ferrite particles, which are spherical particles, and the second ferrite particles, which are irregularly shaped particles, are added, a high noise suppression effect can be obtained over a wide frequency range from the hundred megahertz range to the gigahertz range.

Next, the following simulation result regarding thermal conductivity was performed.

In the experiment, simulation of thermal conductivity was performed using analysis models in which the matrix material was silicone gel and the filler content was 60 vol%.

The filler included the first ferrite particles, which were spherical particles (Ni-Zn) with a diameter of 0.1 mm, the second ferrite particles, which were irregularly shaped particles (Ni-Zn) with an average particle diameter of 0.005 mm to 0.04 mm, and alumina (heat-conducting material) with an average particle diameter of 0.005 mm to 0.01 mm.

In the experiment, the number of first ferrite particles was set to 2, 4, 6, and 11, and the temperature distribution between the bottom surface and the top surface of each analysis model was analyzed.

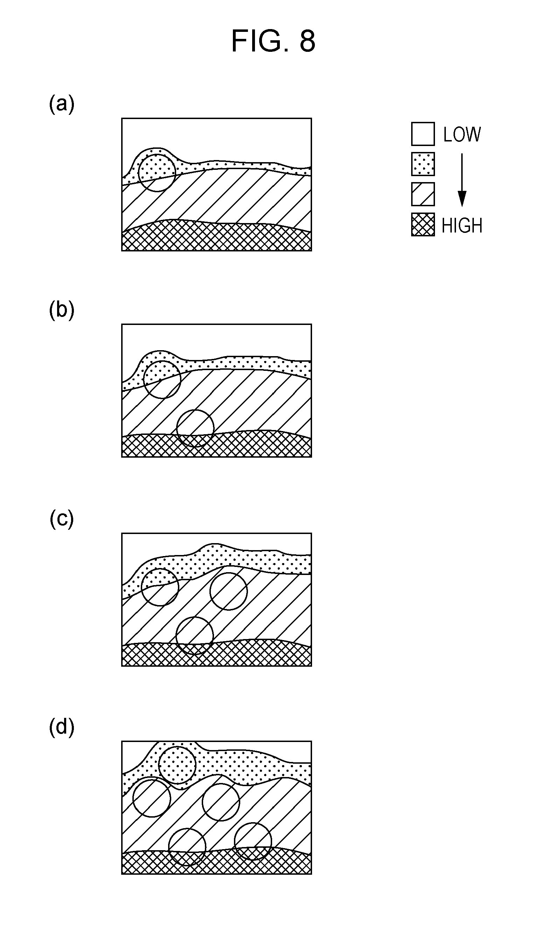

Fig. 8 illustrates the simulation results (schematic diagrams) of the temperature distribution between the bottom surface and the top surface along cross sections of analysis models taken along the thickness direction.

In the diagrams in Fig. 8, the circles are the first ferrite particles that appear in the cross sections. In the experiment, it was assumed that the bottom surface was heated to 70°C. Fig. 8(a) shows the experiment result obtained when the number of first ferrite particles was 2. Fig. 8(b) shows the experiment result obtained when the number of first ferrite particles was 4. Fig. 8(c) shows the experiment result obtained when the number of first ferrite particles was 6. Fig. 8(d) shows the experiment result obtained when the number of first ferrite particles was 11.

As is clear from Fig. 8, the thermal conductivity increased as the number of first ferrite particles increased. In Fig. 8(a), the maximum temperature at the top surface of the analysis model was 64.6°C. In Fig. 8(b), the maximum temperature at the top surface of the analysis model was 64.8°C. In Fig. 8(c), the maximum temperature at the top surface of the analysis model was 65.1°C. In Fig. 8(d), the maximum temperature at the top surface of the analysis model was 66.3°C.

In the experiment, the content of the entire filler was fixed at 60 vol%. Therefore, it was found from the experiment that the first ferrite particles, which are spherical particle size, largely contribute to the thermal conductivity.

The coefficient of thermal conductivity can be increased by increasing the content of the first ferrite particles. However, if the content of the first ferrite particles is excessively increased, the thermal conductivity will be reduced, owing to a reduction in compressibility. Therefore, to determine the desirable content, heat-conductive noise suppression sheets shown in Table 1 were produced.

**[Table 1]**

| | Magnetic Powder | | Heat-Conducting Material | Matrix Material | Coefficient of Thermal Conductivity (W/mk) |
|---|---|---|---|---|---|
| | Content (vol%) | | Content (vol%) | Content (vol%) | |
| | KNI-109GS | KNI-109GSM | AS-40 | SE1896FR | |
| Comparative Example 1 | 55 | | 5 | 40 | 0.994 |
| Comparative Example 2 | | 55 | 5 | 40 | 1.199 |
| Comparative Example 3 | 35 | 20 | 5 | 40 | 1.324 |
| Example 1 | 20 | 35 | 5 | 40 | 1.243 |
| Comparative Example 4 | | 50 | 7.5 | 42.5 | 1.116 |
| Example 2 | 25 | 25 | 7.5 | 42.5 | 1.273 |
| Comparative Example 5 | | 50 | 5 | 45 | 1.097 |
| Comparative Example 6 | | 50 | | 50 | 0.8978 |
| Comparative Example 7 | | 50 KNI-106GSM | | 50 | 0.8859 |
| Example 3 | 20 | 35 KNI-106GSM | 5 | 40 | 1.295 |
| Example 4 | 25 | 20 | | | 0.912 |

Example 1 and Comparative Example 1 shown in Table 1 are the same as those used in the experiment described above with reference to Fig. 5.

Referring to Table 1, sheet forming of Comparative Example 1, in which the volume percentage of the first ferrite particles (KNI-109GS) was considerably large, was difficult. In Comparative Example 1, although the volume percentage of the first ferrite particles was large, conformability between resin and the filler was low, and the air entered the structure. Therefore, the coefficient of thermal conductivity was low. In addition, the sample of Comparative Example 1 in the above-described state had a low compressibility. As a result, the thermal conductivity was extremely low.

In Comparative Example 3 shown in Table 1, the content of the first ferrite particles (KNI-109GS) was 35 vol% and the content of the second ferrite particles (KNI-109GSM) was 20 vol%. In this example, a high coefficient of thermal conductivity was obtained. However, in Comparative Example 3, sheet forming was still difficult owing to the large content of the first ferrite particles. Even when sheet forming of the heat-conductive noise suppression sheet was successfully performed, the sheet was fragile and easily damaged when the sheet was interposed between the semiconductor component and the heat sink and compressed.

In Comparative Examples 2 and 4 to 7, the first ferrite particles were not contained and the content of the second ferrite particles (KNI-109GSM) was set to a considerably large amount, that is, to 50 vol% or 55 vol%. In each example, the coefficient of thermal conductivity was not sufficient.

In contrast, in Examples 1 to 3, sheet forming was successfully performed and high coefficients of thermal conductivity were obtained. In Example, KNI-106GSM manufactured by JEF Chemical Corporation was used as the second ferrite particles. In Examples 1 to 3, not only the coefficient of thermal conductivity but also the compressibility was high, as described below, so that high thermal conductivity was obtained. In Example 4, the content of the first ferrite particles was larger than that of the second ferrite particles. The coefficient of thermal conductivity was lower than those in Examples 1 to 3. However, a large amount of first ferrite particles, which largely contribute to increasing the coefficient of thermal conductivity, was added. Therefore, although the content of the filler is smaller than those in Comparative Examples 6 and 7, the coefficient of thermal conductivity is higher than those in Comparative Examples 6 and 7. In Example 4, although no data is presented, the compressibility can be further increased since the total content of filler including the first and second ferrite particles is small. Therefore, it can be expected that high thermal conductivity can be obtained.

Next, a heat-conductive noise suppression sheet similar to the sample of Example 1 except that the sheet contains 2.5 vol% alumina and 42.5 vol% matrix material was manufactured.

In addition, a heat-conductive noise suppression sheet (EGR-11F) manufactured by Fuji Polymer Co., Ltd. was used as Comparative Example 8.

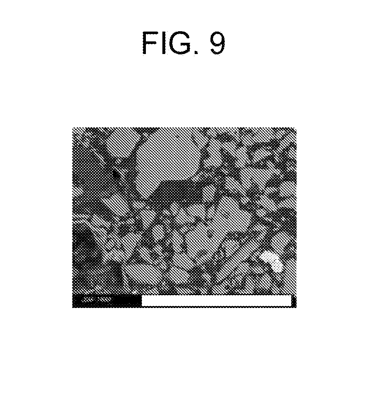

Fig. 9 is a cross-sectional photograph (SEM photograph) of the heat-conductive noise suppression sheet of Comparative Example 8. It is clear from Fig. 9 that the ferrite particles are not spherical particle size, but are irregularly shaped particles that correspond to the second ferrite particles according to the present embodiment.

The above-described heat-conductive noise suppression sheets were exposed to an environment with a temperature of 130°C and a humidity of 85% for 20 hours. Then, the heat-conductive noise sheets were subjected to stress by performing 20 cycles of 50% compression at 150°C for 30 minutes and 50% compression at -65°C for 30 minutes.

After the above-described stress was applied, each heat-conductive noise suppression sheet was placed on a heater, and the temperature difference between the heater-side surface of the heat-conductive noise suppression sheet and the surface opposite the heater-side surface was measured while the heat-conductive noise suppression sheet was compressed in the vertical direction.

In the experiment, the temperature difference was measured while the input to the heater was changed to 5 W, 10 W, and 15 W.

The experiment results are shown in Table 2.

**[Table 2]**

| | Input [W] | Output (Temperature Difference) | | |
|---|---|---|---|---|
| | | High-Temperature Side | Low-Temperature Side | Temperature Difference |
| | 5 | 51.2 | 34.7 | 16.5 |
| Comparative Example 8 | 10 | 77.2 | 43.1 | 34.1 |
| | 15 | 109.7 | 52.1 | 57.6 |
| Example 1 (contains 2.5 alumina and 42.5 matrix material) | 5 | 47.7 | 32.8 | 14.9 |
| | 10 | 75.1 | 42 | 33.1 |
| | 15 | 98.2 | 49.3 | 48.9 |

As is clear from Table 2, the temperature differences in Example was smaller than those in Comparative Example. Thus, it was found that Example has a high coefficient of thermal conductivity and high compressibility, and therefore has higher thermal conductivity.

### Reference Signs List

1 electronic component
2 heat sink
3 heat-conductive noise suppression sheet
4 first ferrite particles (spherical particles)
5 second ferrite particles (irregularly shaped particles)
6 heat-conducting material
7 matrix material

## Claims

1. A heat-conductive noise suppression sheet, comprising:
first ferrite particles, second ferrite particles, and a matrix material,
wherein the first ferrite particles are spherical particles having an average particle diameter in the range of 50 µm to 150 µm, the content of the first ferrite particles with respect to the total amount of solid components being in the range of 5 vol% to 25 vol%, and
wherein the second ferrite particles are irregularly shaped particles having an average particle diameter in the range of 50 µm or less, the content of the second ferrite particles with respect the total amount of solid components being in the range of 5 vol% to 45 vol%.

2. The heat-conductive noise suppression sheet according to Claim 1, wherein the content of the first ferrite is 10 vol% or more.

3. The heat-conductive noise suppression sheet according to Claim 1, wherein the content of the first ferrite is 20 vol% or more.

4. The heat-conductive noise suppression sheet according to one of Claims 1 to 3, wherein the content of the second ferrite is 30 vol% or more.

5. The heat-conductive noise suppression sheet according to Claim 1, wherein the content of the first ferrite particles is in the range of 20 to 25 vol%, and the content of the second ferrite particles is in the range of 10 vol% to 20 vol%.

6. The heat-conductive noise suppression sheet according to one of Claims 1 to 5, wherein the irregularly shaped particles are formed by crushing the spherical particles.

7. The heat-conductive noise suppression sheet according to one of Claims 1 to 6, further comprising a heat-conducting material.

8. The heat-conductive noise suppression sheet according to Claim 7, wherein the heat-conducting material is aluminum oxide having an average particle diameter in the range of 5 µm to 25 µm, and the content of the heat-conducting material with respect to the total amount of solid components is in the range of 2.5 vol% to 10 vol%.

9. The heat-conductive noise suppression sheet according to one of Claims 1 to 8, wherein the matrix material is silicone gel, and the content of the matrix material with respect to the total amount of solid components is in the range of 30 vol% to 57.5 vol%.

## Amended claims

### Amended claims under Art. 19.1 PCT

**1.** Amended) A heat-conductive noise suppression sheet, comprising:
first ferrite particles, second ferrite particles, and a matrix material,
wherein the first ferrite particles are spherical particles having an average particle diameter in the range of 50 µm to 150 µm, the content of the first ferrite particles with respect to the total amount of solid components being in the range of 5 vol% to 25 vol%,
wherein the second ferrite particles are irregularly shaped particles having an average particle diameter in the range of 50 µm or less, the content of the second ferrite particles with respect the total amount of solid components being in the range of 5 vol% to 45 vol%, and
wherein the heat-conductive noise suppression sheet further comprises a heat-conducting material.

**2.** The heat-conductive noise suppression sheet according to Claim 1, wherein the content of the first ferrite is 10 vol% or more.

**3.** The heat-conductive noise suppression sheet according to Claim 1, wherein the content of the first ferrite is 20 vol% or more.

**4.** Amended) A heat-conductive noise suppression sheet, comprising:
first ferrite particles, second ferrite particles, and a matrix material,
wherein the first ferrite particles are spherical particles having an average particle diameter in the range of 50 µm to 150 µm, the content of the first ferrite particles with respect to the total amount of solid components being in the range of 20 vol% to 25 vol%, and
wherein the second ferrite particles are irregularly shaped particles having an average particle diameter in the range of 50 µm or less, the content of the second ferrite particles with respect the total amount of solid components being in the range of 20 vol% to 35 vol%.

**5.** Amended) The heat-conductive noise suppression sheet according to one of Claims 1 to 4, wherein the content of the second ferrite is 30 vol% or more.

**6.** Amended) A heat-conductive noise suppression sheet, comprising:
first ferrite particles, second ferrite particles, and a matrix material,
wherein the first ferrite particles are spherical particles having an average particle diameter in the range of 50 µm to 150 µm, the content of the first ferrite particles with respect to the total amount of solid components being in the range of 20 vol% to 25 vol%, and
wherein the second ferrite particles are irregularly shaped particles having an average particle diameter in the range of 50 µm or less, the content of the second ferrite particles with respect the total amount of solid components being in the range of 10 vol% to 20 vol%.

**7.** Amended) The heat-conductive noise suppression sheet according to one of Claims 1 to 6, wherein the irregularly shaped particles are formed by crushing the spherical particles.

**8.** Amended) The heat-conductive noise suppression sheet according to one of Claims 4 to 7, further comprising a heat-conducting material.

**9.** Amended) The heat-conductive noise suppression sheet according to Claim 8, wherein the heat-conducting material is aluminum oxide having an average particle diameter in the range of 5 µm to 25 µm, and the content of the heat-conducting material with respect to the total amount of solid components is in the range of 2.5 vol% to 10 vol%.

**10.** Added) The heat-conductive noise suppression sheet according to one of Claims 1 to 9, wherein the matrix material is silicone gel, and the content of the matrix material with respect to the total amount of solid components is in the range of 30 vol% to 57.5 vol%.
